# EUROPÄISCHE PATENTSCHRIFT

(11) **EP 2 668 226 B1**
(45) Veröffentlichungstag und Bekanntmachung des Hinweises auf die Patenterteilung: **07.12.2016**
(21) Anmeldenummer: 12703988.1
(22) Anmeldetag: 25.01.2012
(51) Int. Cl.: C08J 11/08, G03F 7/42, H01L 21/02, B29B 17/02, C08J 11/06

(54) **TRENNMEDIUM, VERFAHREN UND ANLAGE ZUM TRENNEN VON MEHRSCHICHTSYSTEMEN**
SEPARATING FLUID, METHOD AND INSTALLATION FOR SEPARATING MULTILAYER SYSTEMS
MILIEU DE SÉPARATION, PROCÉDÉ ET INSTALLATION PERMETTANT DE SÉPARER DES SYSTÈMES MULTICOUCHES

(30) Priorität: 25.01.2011 DE 102011000322
(43) Veröffentlichungstag der Anmeldung: 04.12.2013
(73) Patentinhaber: Saperatec GmbH, 33611 Bielefeld (DE)
(72) Erfinder: KERNBAUM, Sebastian, 33611 Bielefeld (DE); SEIBT, Horst, 33611 Bielefeld (DE)
(74) Vertreter: Harrison, Robert John
(86) Internationale Anmeldenummer: PCT/EP2012/051172
(87) Internationale Veröffentlichungsnummer: WO 2012/101189

(56) Entgegenhaltungen:
- EP-A2- 0 761 731
- EP-A2- 1 975 987
- WO-A1-2007/111385
- DE-A1- 4 407 900
- US-A- 5 628 832
- US-B1- 6 696 399

## Beschreibung

Die vorliegende Erfindung betrifft ein Trennmedium zum Trennen von Mehrschichtsystemen zum Zwecke des Recycling.

Ferner betrifft die vorliegende Erfindung ein Verfahren zum Trennen von Mehrschichtsystemen zum Zwecke des Recycling, umfassend eine Waschung mit einem Trennmedium.

Gleichermaßen betrifft die vorliegende Erfindung eine Verwendung eines Trennmediums zum Trennen von Mehrschichtsystemen zum Zwecke des Recycling.

Schließlich betrifft die vorliegende Erfindung eine Anlage zur Durchführung des Verfahrens der eingangs genannten Art.

Der zunehmende Verbreitungsgrad von Photovoltaikmodulen und anderen in Mehrschichtsystemen vorliegenden, insbesondere elektronischen, Gegenständen erhöht den Bedarf an geeigneten Verfahren und Stoffen zur Entsorgung und insbesondere zum Recycling sowohl außer Betrieb genommener Gegenstände als auch von bei deren Herstellung anfallender Produktionsabfälle. Die Aufbereitung und das Recycling zielt dabei insbesondere auch auf die Herstellung von Sekundärrohrstoffen, die dem Wirtschaftskreislauf erneut zugeführt werden können. Außerdem spielen in zunehmendem Maße Fragen des Umweltschutzes eine Rolle, die einer Entsorgung der in Rede stehenden Gegenstände ohne jedwede Aufbereitung ebenfalls entgegenstehen. Diese Rahmenbedingungen führen zu der Anforderung, dass bei dem Recyclingprozess seinerseits möglichst umwelt- und ressourcenschonend vorgegangen werden sollte.

Die Verfahren und Trennmittel der eingangs genannten Art, die derzeit eingesetzt werden, basieren auf der Anwendung von chemischen und thermischen Prozessen für Silizium-Dickschichtmodule wie zum Beispiel kristalline Siliziummodule auf der einen Seite und mechanischen und chemischen Trennprozessen für das Recyceln von Dünnschichtmodulen oder CdTe-Dünnschichtmodulen auf der anderen Seite.

Dabei basieren die Photovoltaikmodule einerseits auf Siliziumwafern, welche mittels Laminierung von Ethylenvinylacetat (EVA) innerhalb zweier Glasscheiben eingebettet und mittels einer geeigneten Rahmung versehen werden, wobei sogenannte SI-Dickschichtmodule entstehen. Die andere Art von Photovoltaikzellen oder Photovoltaikmodulen sind mit Hilfe dünner Schichten hergestellt, die durch physikalische und/oder chemische Dampfabscheidungsverfahren direkt auf Glasscheiben aufgebracht werden. Dabei sind verschiedene Dünnschichtzellvarianten auf dem Markt, wie zum Beispiel amorphes Silizium, mikrokristallines Silizium, Cadmiumtellurid, Kupfer-Indium-Diselenid sowie Galliumarsenid.

Die bekannten Verfahren beruhen also auf einem thermischen Trennprozess, d.h. der Zerstörung der EVA-Klebung, in Verbindung mit chemischen Verfahren zur Reinigung des erhaltenen Siliziumwafers bzw. des Rohsiliziums. Die Verfahren sind mit Nachteil energieintensiv und nur bedingt für Dünnschichtmodule geeignet.

Ein anderes bekanntes Verfahren basiert im Wesentlichen darauf, dass mit Schwefelsäure und Wasserstoffperoxid durch einen Ätzprozess eine Trennung des Mehrschichtsystems hervorgerufen wird. Nachteilig ist, dass die Verwendung derartiger Stoffe zum einen umweltbelastend und zum anderen die Abtrennung und Aufkonzentration der Wertstoffe nach dem Ätzvorgang aufwendig sein kann.

Mit Nachteil gehen bei den bekannten Verfahren die Materialien aufgrund der verwendeten Säuren zur Ablösung von Schichten vollständig in Lösung. Daher muss mit Nachteil durch energetisch und materialseitig aufwendige Verfahren, wie zum Beispiel die Elektrolyse, eine Herauslösung dieser Materialien aus der verwendeten Ätzlösung erfolgen, damit sie für eine weitere Verwendung zur Verfügung stehen.

Die Europäische Patentanmeldung Nr. EP 1 975 987 (ATMI) betrifft eine Zusammensetzung mit mindestens einem Ätzmittel, mindestens einem Tensid und mindestens einem organischen Lösungsmittel oder Wasser. Die Zusammensatzung ist geeignet zur Entfernung von mindestens einem Material, wie Barriere-Schichten, Fotolack-Schichten und sonstige Beschichtungen einer mikroelektronischen Vorrichtung.

Die Deutsche Patentanmeldung DE 44 07 900 (BASF) betrifft ein Verfahren zur Recycling von Rohmaterialien aus kleingeschnittenen Abfällen von magnetischen Aufzeichnungsträgern, die aus einem polymeren Schichtträger und einer darauf befindlichen Magnetschicht sind. Das Magnetpulver und das Schichtträgermaterials werden durch Behandlung in einem alkalischen Medium bei einer Temperatur von 60-90°C wiedergewonnen. Der kleingeschnittene Abfall wird in einer Lösung behandelt. Die Lösung umfasst Phosphate, Tenside sowie Komplexbildner davon mit einem oder mehreren organischen Lösungsmittelnd und/oder Wasser. Das abgelöste Magnetpulver wird durch Waschen und/oder Sedimentieren oder in einem Magnetabscheider vom Schichtträger getrennt.

Internationale Patentanmeldung Nr. WO 2007/111385 (Nippon Sheet Glass) betriff eine Trennflüssigkeit, welche ein Tensid mit voreingestellter Oberflächenspannung enthält. Die Trennflüssigkeit trennt die Zwischenschicht zwischen Glasplatten in einem Verbundglas. Diese Anmeldung offenbart die Trennung von laminierten Glasoberflächen. Die zur Laminierung benutzte Schicht wird mittels mechanischer Kräfte zerstört und von der Glasoberfläche entfernt. Zur Zerstörung der Schicht werden Planzenfaserteilchen benutzt, vorzugsweise kommen hier Reiskleie und ähnliche Produkte zum Einsatz. Durch den mechanischen Aufprall werden die Laminatteile von der Glasoberfläche entfernt. Das Glas wird gewaschen und dem Recycling zugeführt. Die Kleie mit den Laminatteilchen wird in der Regel verbrannt - z.B. Energiegewinnung.

Keine dieser drei Patentschriften offenbart eine nanoskalige Dispersion zum Trennen der einzelnen Schichten in einem Mehrschichtsystem.

Vor dem genannten Hintergrund ist Aufgabe der vorliegenden Erfindung, ein Trennmedium, ein Verfahren, eine Verwendung sowie eine Anlage der eingangs genannten Art anzugeben, die es jeweils ermöglichen, auf verfahrenstechnisch vergleichsweise einfache und die Umwelt möglichst wenig belastende Weise die Trennung von Mehrschichtsystemen, insbesondere Photovoltaikmodulen, mit hoher Recyclingquote durchzuführen.

Diese Aufgabe wird bezüglich des Trennmediums mit einem Trennmedium der eingangs genannten Art gelöst, welches eine nanoskalige Dispersion ist, welche aus einer organischen Komponente, einer wässrigen Komponente und mindestens einem Tensid gebildet ist. Im Rahmen der vorliegenden Erfindung wird der Begriff nanoskalige Dispersion als Oberbegriff verwendet, der Mikroemulsionen gleichermaßen wie Miniemulsionen umfasst und sich auf eine stabile, optisch isotrope Dispersion bezieht, die zwei nicht mischbare Komponenten enthält und durch mindestens eine amphiphile Komponente stabilisiert wird. Mit Hilfe des erfindungsgemäßen Trennmediums ist die Trennung von Verklebungen und Beschichtungen möglich, indem Grenzflächenspannungen zwischen den Phasen verklebter und beschichteter Materialien herabgesetzt und eine Trennung herbeigeführt wird. Bei Photovoltaikmodulen kann mit dem erfindungsgemäßen Trennmedium beispielsweise eine Trennung der Glas-Glas-Verklebung, welche häufig unter Einsatz von EVA oder ähnlichen Stoffen erfolgt, oder eine Trennung der Edelmetallbeschichtung und/oder Halbleiterbeschichtungen von Dünnschichtmodulen erzielt werden. Das Trennmedium nach der Erfindung lässt sich auch anwenden, um Photovoltaikmodule zu trennen, bei denen eine Glas-Glas-Verbindung mittels einer PVB-Folie ähnlich wie bei Autoglasfrontscheiben vorhanden ist. Mit Vorteil sind erfindungsgemäße nanoskalige Dispersionen kostengünstig herstellbar. Außerdem ermöglichen sie die weitestgehend verlustfreie Abtrennung und Rückgewinnung von wertvollen Stoffen, um diese anschließend erlösbehaftet zu verwerten. Nach dem Einsatz ist mit Vorteil die Aufarbeitung und Wiederverwendung der erfindungsgemäßen nanoskaligen Dispersionen möglich. Durch den Einsatz der Trennmedien wird im Unterschied zu den bekannten durch Ätzung geprägten Verfahren, bei welchen auch die Wertstoffe in Lösung gehen, eine Separation der werthaltigen Materialien, welche sich flächig, also in makroskopischen Einheiten ablösen, durch einfache Filtrierung möglich Die Verwendung der erfindungsgemäßen Stoffmischung als Trennmedium führt also nicht zur chemischen Auflösung, sondern zur kleinteiligen, beispielsweise blättrigen oder streifigen, Ablösung der Schichten jeweils an der Verbundfläche. Dabei können sowohl dünne Schichten von Metallen oder Halbleitern oder Graphit von Substratträgerschichten wie zum Beispiel Glas oder Metall abgelöst werden. Auch ist es möglich, dass verbundene dünne Schichten aus zwei oder mehr dünnen Einzelschichten in ihre Einzelschichten getrennt werden. Dabei kommt es zu keinen praktisch bedeutsamen Materialverlusten und die Fraktionen der unterschiedlichen Materialien können in nachgeschalteten Separationsstufen aus dem Schlamm oder aus der Aufschwemmung separiert werden.

Die organische Komponente der nanoskaligen Dispersion bei der Verwendung zum Trennen von Mehrschichtsystemen dem Aufquellen des Kunststoffs. Außerdem dient die organische Komponente erfindungsgemäß dazu, eventuell vorhandene Bindemittel im Mehrschichtsystem abzulösen, um so die Trennung zu unterstützen. Der Einsatz von organischen Flüssigkeiten für die organische Komponente kann sehr unterschiedlich sein. Die Wahl der organischen Flüssigkeit ist einmal abhängig von den Klebverbindungen bei den Solarmodulen und schließlich auch von der Verwendung von organischen Haftvermittlern bei den aufgebrachten dünnen Halbleiterschichten.

Unter dem Begriff wässrige Komponente wird im Rahmen der Erfindung die Summe von Wasser in Reinform und aller wässrigen Anteile, die durch die Zugabe weiterer Bestandteile hinzugefügt werden, verstanden. Weitere den Anteil der wässrigen Komponente an dem erfindungsgemäßen Trennmedium erhöhende wässrige Anteile könnten insbesondere in wässrigen Lösungen enthalten sein. Der Anteil der wässrigen Komponente gibt somit den Anteil Wasser im Gesamtgemisch an. Das Wasser kann also auch Bestandteil anderer Zugabe-Komponenten sein.

Wie für sich genommen bekannt, dient das Tensid zur Belegung der freien Oberflächen und zur Nutzung der kapillaraktiven Kräfte für die Bildung weiterer Oberflächen. Insbesondere hat sich als organische Komponente eine wässrige Zitronensäure als geeignet erwiesen im Rahmen der Erfindung.

Im Rahmen der Erfindung ist es vorteilhaft, wenn die organische Komponente wasserunlösliche Öle und/oder wasserunlösliche Lösungsmittel enthält.

In Weiterbildung der Erfindung weist die wässrige Komponente innerhalb der nanoskaligen Dispersion eine Konzentration von mindestens 60 Gewichts-%, vorzugsweise etwa 70 Gewichts-%, auf. Im Rahmen der Erfindung haben sich Konzentrationen von mindestens 60 Gewichts-% bis max. 85 Gewichts-% als besonders geeignet erwiesen.

In bevorzugter Ausgestaltung des erfindungsgemäßen Trennmediums ist das Tensid gewählt aus der Gruppe gebildet durch anionische Tenside, nicht-ionische Tenside, amphotere Tenside, oder deren Kombinationen. Definitionsgemäß weisen Tenside mindestens eine hydrophile und eine hydrophobe funktionelle Gruppe auf. Anionische Tenside weisen als funktionelle Gruppe in der Regel Carboxylat-, Sulfat- oder SulfonatGruppen auf. Ein nicht-ionisches Tensid kann im Rahmen der Erfindung insbesondere eine Polyether-Kette, vorzugsweise eine Alkyl-Polyether-Kette, sein. Ein amphoteres Tensid kann erfindungsgemäß sowohl anionische als auch kationische Gruppen enthalten und sich demnach je nach pH-Wert wie ein anionisches oder ein kationisches Tensid verhalten oder aufgrund seiner Struktur zwitterionisch bleiben. Zwitterionische Tenside verhalten sich in der Regel pH-Wert unabhängig. Im Rahmen der Erfindung ist jede Kombination von nichtionischen, zwitterionischen und anionischen Tensiden grundsätzlich geeignet. In speziellen Fällen kann jedes der genannten Tenside auch als alleinige Tensidkomponente eingesetzt werden. Im Rahmen der Erfindung wurde festgestellt, dass sich durch die Beigabe eines anionischen und/oder amphoteren Tensids die Kriechgeschwindigkeit des erfindungsgemäßen Trennmediums beim Trennvorgang in der Grenzflächenschicht zwischen zu trennenden Schichten des Mehrschichtsystems erhöhen lässt.

Gemäß einer bevorzugten Ausgestaltung enthält das Trennmedium anionische Tenside, nicht ionische Tenside, amphotere Tenside oder deren Kombination.

Eine bevorzugte Ausgestaltung sieht vor, dass das nicht-ionische Tensid innerhalb der nanoskaligen Dispersion eine Konzentration im Intervall von 2 Gewichts-% bis 12 Gewichts-%, insbesondere von 5 Gewichts-% bis 9 Gewichts-%, aufweist.

In anderer günstiger Ausgestaltung des erfindungsgemäßen Trennmediums weist das anionische Tensid und/oder das amphothere Tensid innerhalb der nanoskaligen Dispersion eine Konzentration von höchstens 10 Gewichts-%, insbesondere etwa 6 Gewichts-%, auf.

Um sicherzustellen, dass das nicht-ionische Tensid gut in Wasser löslich ist, ist in Ausgestaltung der Erfindung vorgesehen, dass das nicht-ionische Tensid einen HLB-Wert im Intervall von 12 bis 13 aufweist. Der HLB-Wert (hydrophilic-lipophilic-balance) gibt an, wie ausgeprägt das Gleichgewicht zwischen den hydrophilen Kopfgruppen und den hydrophoben Kohlenwasserstoffresten ist. Er ist definiert durch das Produkt des Faktors 20 mit der relativen Anteil der Molmasse des hydrophilen Molekülteils an der Gesamtmolmasse.

In weiterer Ausgestaltung des erfindungsgemäßen Trennmediums enthält die nanoskalige Dispersion weiter ein Hydrotrop zur Stabilisierung der Dispersion. Das Hydrotrop dient erfindungsgemäß zur Erhöhung der kapillaraktiven Kräfte der eingesetzten Tenside und zur Stabilisierung der nanoskaligen Dispersion. Das Hydrotrop dient also erfindungsgemäß zum einen dazu, die Löslichkeit organischer Substanzen zu verbessern. Zum anderen vermag es erfindungsgemäß durch seine gute Wechselwirkung mit dem Tensid bzw. den Tensiden an der Grenzfläche die kapillaraktiven Kräfte der Tenside anzuregen, wodurch erreicht wird, dass die Belastbarkeit der erfindungsgemäßen nanoskaligen Dispersion erhöht wird. Andererseits kann die Einsatzkonzentration der Tenside bei gleichbleibender Wirkung verringert werden. Dies ist vorteilhaft für die Herstellungskosten des erfindungsgemäßen Trennmediums. Als besonders geeignete Hydrotrope haben sich im Rahmen der Erfindung Amino-Phosphonsäuren oder die para-Toluolsulfonsäure erwiesen.

In vorteilhafter Ausgestaltung des Trennmedium umfasst das Hydrotrop ein kurzkettiges, polares organisches Molekül. Im Rahmen der Erfindung haben sich Kettenlängen von bis zu sechs oder von bis zu fünf Kohlenstoffatomen als besonders geeignet erwiesen. Dieses kann sich beispielsweise in Grenzphasen anordnen. Ferner kann es mit Vorteil mit den Tensiden bzw. möglicherweise vorhandenen Cotensiden wechselwirken. Die Wechselwirkung der Tenside mit dem Hydrotrop führt zu einer Verstärkung der kapillaraktiven Kräfte, die für die Trennung in der Regel verantwortlich zu machen sind.

Insbesondere kann das Hydrotrop in Ausgestaltung der Erfindung eine organische Säure oder ein Salz einer organischen Säure umfassen. Als Hydrotrope können vorzugsweise organische Säuremoleküle eingesetzt werden, die, wenn sie als Säuren eingesetzt werden, einen von der organischen Säure abhängigen pH-Wert erzeugen. Denn viele Trennungen von harten Oberflächen werden durch den sauren Charakter der Mikroemulsion begünstigt. Sollte der Trennvorgang im neutralen bzw. alkalischen Bereich besonders begünstigt werden, lassen sich im Rahmen der Erfindung die entsprechenden Alkalisalze bzw. Aminsalze einsetzen. Bei den Aminsalzen können bevorzugt die Alkanolamine der organischen Säuren eingesetzt werden. Die Alkanolamine sind in diesem Fall im Rahmen der Erfindung ebenfalls als Hydrotrope anzusehen.

Um die Bildung einer einer nanoskaligen Dispersion im Sinne der Erfindung zu begünstigen, enthält in Weiterbildung des erfindungsgemäßen Trennmediums die nanoskalige Dispersion ein Cotensid. Vorzugsweise hat sich erfindungsgemäß Isobutanol als geeignet erwiesen. In Anwendungen, bei denen Isobutanol wegen des vergleichsweise niedrigen Flammpunkts nicht für die Industrialisierung geeignet ist, können erfindungsgemäß gleichermaßen längerkettige Alkohole oder Derivate davon eingesetzt werden.

In spezieller Ausgestaltung der Erfindung enthält das Cotensid einen kurzkettigen Alkohol, vorzugsweise Ethylhexanol und/oder Alkylmonoglykolether. Im Rahmen der Erfindung geeignete Alkohole müssen etwas bis wenig in Wasser löslich sein und gleichzeitig etwas bis gut in der eingesetzten organischen Phase löslich sein. Außerdem müssen sie an der Grenzfläche mit den eingesetzten Tensiden wechselwirken und somit an der Grenzfläche gemeinsam mit den Tensiden eine monomolekulare flüssigkristalline Schicht bilden.

Das Trennmedium gemäß der Erfindung kann zusätzlich eine basische Komponente, insbesondere NaOH, zur Erhöhung des pH-Wertes enthalten.

Die auf ein Verfahren der eingangs genannten Art gerichtete Aufgabe wird durch ein derartiges Verfahren gelöst, bei welchem mittels des Trennmediums zumindest Abschnitte einzelner oder mehrerer Schichten von dem Mehrschichtsystem derart abgelöst werden, dass das Material der Schichten dabei im wesentlichen nicht in Lösung geht.

In Ausgestaltung des erfindungsgemäßen Verfahrens ist das Trennmedium nach einem der Ansprüche 1 bis 7 ausgestaltet.

Im Unterschied zu bekannten Verfahren zum Trennen insbesondere von Photovoltaikmodulen ist es mit dem erfindungsgemäßen Verfahren möglich, gezielt nur das Klebemittel zwischen den Schichten auszulösen, ohne jedoch gleichzeitig das Schichtmaterial selber zu lösen. Mit Vorteil wird dadurch die weitere Rückgewinnung der Bestandteile des Mehrschichtsystems wesentlich vereinfacht. Auch kann die Rückgewinnungsquote aus diesem Grunde gegenüber auf dem Einsatz von Säuren basierenden Verfahren verbessert werden. Der Vorteil der Erfindung zeigt sich in diesem Zusammenhang insbesondere gegenüber vorbekannten Verfahren, bei denen mineralische Säuren eingesetzt werden, da diese bei dem erfindungsgemäßen Verfahren mit Vorteil entfallen können.

Dabei kann bei Einsatz geeigneter Trennmedien eine gezielte Delaminierung der Verbundschichten erzielt werden. Dazu ist eine Benetzung der Schichten und insbesondere der Rand- und Kantenbereiche der Mehrschichtsysteme erforderlich, damit das Trennmittel zwischen die Schichten eindringen kann, um diese zu separieren. Weil erfindungsgemäß die Schichten nicht aufgelöst sondern abgelöst werden, gestaltet sich die Rückgewinnung des Schichtmaterials besonders einfach. Das erfindungsgemäße Verfahren kann daher mit Vorteil insbesondere zur wirtschaftlichen Aufbereitung von Photovoltaikmodulen, Batteriezellen oder Bildschirmen verwendet werden.

Im Rahmen der Erfindung ist es vorteilhaft, wenn die Waschung in einem das Trennmedium enthaltenden Behälter, insbesondere Tauchbehälter, durchgeführt wird, indem die zu trennenden Mehrschichtsysteme in den Behälter eingetragen werden, wobei vorzugsweise eine Relativbewegung zwischen dem Trennmedium und dem Behälter erzeugt wird. Diese Vorgehensweise führt mit Vorteil dazu, dass das Trennmedium besonders gut an die zu lösende Trennschicht herangetragen wird, um dort aufgrund von kapillaraktiven Kräften die angestrebte Trennung zu erzielen. Insbesondere können mehrere Tauchbäder mit rotierenden Trommeln eingesetzt werden, wie es für sich genommen zum Beispiel in der Galvanik bekannt ist. Unter den Begriff Waschung fällt im Rahmen der Erfindung insbesondere die Benetzung mit Trennmedium oder die Waschung in Trennmedium. Insbesondere können im Rahmen der Erfindung auch rotierende Behälter eingesetzt werden.

Wenn in Ausgestaltung des erfindungsgemäßen Verfahrens der Behälter eine Trichterform aufweist, kann die Waschung in dem Trichter vorgenommen werden.

In Ausgestaltung des erfindungsgemäßen Verfahrens wird der Behälter rotiert, um die Relativbewegung zu erzeugen. Mit Vorteil begünstigt man auf diese Weise, dass das Trennmedium gemäß der Erfindung mit der zu lösenden Trennschicht in Kontakt kommt.

In anderer günstiger Ausgestaltung des erfindungsgemäßen Verfahrens wird die Relativbewegung durch Rühren und Befördern des Trennmediums innerhalb des Behälters erzeugt. Insbesondere kann als Behälter ein Trichter verwendet werden, welcher eine Schnecke beinhaltet. Mittels der Schnecke wird zum einen das Trennmedium in Bewegung versetzt. Zum anderen kann mittels der Schnecke sowohl der Eintrag als auch der Austrag der zu recycelnden Mehrschichtsysteme bewirkt werden.

In weiterer bevorzugter Ausgestaltung des Verfahrens gemäß der Erfindung wird der Behälter in Vibrationen versetzt. Insbesondere kann ein Vibrationstisch mit einer Gegenströmung verwendet werden, um auch den Partikelaustrag zu ermöglichen.

Die Waschung kann bevorzugt gemäß dem erfindungsgemäßen Verfahren in einem Gegenstromverfahren durchgeführt werden.

Das erfindungsgemäße Verfahren wird weiter verbessert, wenn die Mehrschichtsysteme vor der Waschung mechanisch zerkleinert werden und/oder eine Größenklassierung vorgenommen wird. Dabei dient die Zerkleinerung vor allem der Verbesserung der Trennleistung aufgrund einer vergrößerten Angriffsfläche gegenüber dem Trennmedium. Zusätzlich führt die Zerkleinerung auch zu einer vereinfachten Handhabbarkeit der zu bearbeitenden Mehrschichtsysteme. Vorzugsweise werden erfindungsgemäß die zu bearbeitenden Mehrschichtsysteme, also insbesondere Photovoltaikmodule oder Produktionsabfälle, in ca. 10 bis 30 cm² große Teile zerkleinert. Im Rahmen der Erfindung sind aber auch andere Größen der Teile möglich. Die Zerkleinerung kann dabei, wie dem Fachmann für sich genommen bekannt, mittels Brechern wie zum Beispiel Shreddernerfolgen. Die Klassierung nach Größen vereinfacht ebenfalls die Handhabbarkeit, da zum Beispiel Schnecken für eine bestimmte Größenklasse von zu behandelnden Mehrschichtsystemen ausgelegt und dimensioniert werden können. Die Größenklassierung kann erfindungsgemäß im einfachsten Fall durch Siebung durchgeführt werden.

Wenn in Ausgestaltung des erfindungsgemäßen Verfahrens eine oder mehrere Schichten des Mehrschichtsystems durchdringende Defektstellen erzeugt werden, erhält man mit Vorteil ebenfalls eine Vergrößerung der Angriffsfläche für das Trennmedium. Eine Defektstelle kann schnittartig, lochartig oder in jeder anderen das Schichtsystem unterbrechenden Weise ausgebildet sein. Die Erzeugung der Defektstellen kann zum Beispiel durch Anritzen des Mehrschichtsystems vor oder während der Behandlung mit dem Trennmedium vorgenommen werden. Beim Anritzen können unterschiedliche Anzahlen von Schichten unterbrochen werden. Die Erzeugung der Defektstellen kann mit mechanischen Schneidmitteln, mit Laserstrahlen, mittels Beschießen mit scharfkantigen Partikeln-beispielsweise Sandstrahlen - , mittels Knicken, Brechen, Shreddern, Mahlen erfolgen. Entscheidend ist erfindungsgemäß jeweils, dass eine Defektstelle in mindestens einer Schicht des Mehrschichtsystems erzeugt wird, in die das Trennmedium bevorzugt eindringen kann. Dabei ist es möglich, aber nicht zwingend erforderlich, dass auch das tragende Substrat des Mehrschichtsystems zerteilt wird. Es können einseitig beschichtete und nicht mit Glas oder Folie abgedeckte Substrate angeritzt werden.

In bevorzugter Ausgestaltung des erfindungsgemäßen Verfahrens wird nach der Waschung eine Separierung, insbesondere mittels eines Schwimm-Sink-Verfahrens, unter Einwirkung des Trennmediums abgetrennter Bestandteile des Mehrschichtsystems von dem mit diesen beladenen Trennmedium durchgeführt, wobei vorzugsweise eine Separierung nach Nicht-Eisen-Bestandteilen, insbesondere Glas und/oder Aluminium, Edelmetallen und/oder Kunststoffschicht vorgenommen wird. Das Schwimm-Sink-Verfahren ist dabei aufgrund der erfindungsgemäßen Verwendung einer nanoskaligen Dispersion möglich. Es ist einfacher und kostengünstiger durchführbar, als die Trennverfahren herkömmlicher Recyclingverfahren, welche auf thermischer Trennung oder dem Einsatz von Säure basieren. Neben dem hier nur beispielhaft genannten Schwimm-Sink-Verfahren sind im Rahmen des erfindungsgemäßen Verfahrens jedoch auch alle anderen dem Fachmann bekannten Verfahren zur Separierung einsetzbar. Mit der Separierung kann auch die EVA-Folie wiedergewonnen werden. Auch ein häufig zur Befestigung und Stabilisierung von Photovoltaikmodulen eingesetzter Aluminium-Rahmen kann zurückgewonnen werden. Dies ist zum Beispiel bei einem thermischen Trennprozess, wie er herkömmlich eingesetzt wird, nicht möglich, da bei der thermischen Trennung die EVA-Klebung zerstört wird. Die Separierung kann erfindungsgemäß auch eine einfache Filterung umfassen, um feste Bestandteile auf die einfachste Weise aus dem mit diesen beladenen Trennmedium zu separieren.

Es ist im Rahmen der Erfindung vorteilhaft, wenn die Separierung mittels eines Filterverfahrens durchgeführt wird, indem abgetrennte Bestandteile des Mehrschichtsystems, vorzugsweise mechanisch, zurückgehalten werden. Zum Beispiel können mittels eines Filterelements die abgetrennten Bestandteile zurückgehalten werden.

In alternativer Ausgestaltung des erfindungsgemäßen Verfahrens kann zur Separierung ein Luftblasen-Floating Verfahren durchgeführt werden. Bei diesem werden die abgelösten Schichtteile, die dünnflächig und leicht sind, aufgrund deren verhältnismäßig großer Oberfläche von Luftblasen mitgenommen und dadurch aufgeschwemmt. Die schwereren dickwandigeren Partikel setzen sich hingegen am Boden ab, sodass eine Separation erfolgt.

Eine Separation ist im Rahmen des erfindungsgemäßen Verfahrens gleichermaßen möglich durch Ausnutzung der Unterschiedlichkeit der magnetischen oder elektrischen Eigenschaften des zu trennenden Guts.

Allgemein ist die Verwendung einer Nanodispersion gemäß der Erfindung vorteilhaft für die Qualität der erhältlichen Wertstoffe. Für die Glasfraktion aus der herkömmlichen Photovoltaikmodulaufbereitung blieb bis dato beispielsweise nur der Weg in die Schaumglas- oder die Isoliermaterialherstellung. Das erfindungsgemäße Verfahren basierend auf einer Verwendung eines erfindungsgemäßen Trennmittels in Form einer nanoskaligen Dispersion vermag hingegen Glas in hochwertiger Qualität zu liefern.

Die Umweltverträglichkeit des erfindungsgemäßen Recyclingverfahrens wird noch verbessert, wenn das Trennmedium nach der Waschung zurückgewonnen und wiederverwendet wird. Die speziellen vorteilhaften Eigenschaften des erfindungsgemäßen Trennmediums ermöglichen ein Auftrennen der Mehrschichtsysteme derart, dass die einzelnen Bestandteile auf einfache Weise separierbar sind und somit eine Wiederverwendung des Trennmediums ermöglicht wird.

Die auf eine Verwendung gerichtete Aufgabe wird erfindungsgemäß durch die Verwendung eines Trennmediums nach einem der Ansprüche 1 bis 7 zum Trennen von Mehrschichtsystemen, insbesondere Photovoltaikmodulen, zum Zwecke des Recycling gelöst. Diese Verwendung des Trennmediums im Zusammenhang mit der Trennung von Mehrschichtsystemen wie zum Beispiel Photovoltaikmodulen führt mit Vorteil zu einer besonders umweltverträglichen Wiederaufbereitbarkeit von Photovoltaikmodulen. Zum anderen ist damit eine besonders hohe Recyclingquote erreichbar. Außerdem ist die Qualität der erhaltenen Recyclingprodukte besser als dies bei der Verwendung beispielsweise von Säuren, wie insbesondere mineralischen Säuren, zur Trennung der Fall ist.

Eine andere erfindungsgemäße Verwendung des Trennmediums ist dessen Verwendung zum Trennen von Batteriemodulen und Akkumulatoren. In diesem Fall hat sich erfindungsgemäß gezeigt, dass sich die fest aufgebondeten Carbonschichten mit Vorteil direkt von den Metallschichten lösen, sodass dünne flächige Fragmente der jeweiligen Schichten gewonnen werden, die leicht separiert werden können. Dabei werden die Materialien im wesentlichen nicht chemisch gelöst oder sonstwie verändert. Insbesondere ist es gemäß dieser erfindungsgemäßen Verwendung mit Vorteil nicht erforderlich, starke Säuren, wie beispielsweise mineralische Säuren, einzusetzen, um die angestrebte Ablösung der Carbonschichten von den Metallschichten zu erzielen.

Eine weitere erfindungsgemäße Verwendung des Trennmediums ist dessen Verwendung zum Trennen von Flachbildschirmen und ähnlichen Displays. In diesem Fall hat sich zum Beispiel für die Trennung von, insbesondere transparenten, optisch aktiven und anderen, Folien, Gläsern, transparenten Halbleitern und anderen Schichten die Eignung des erfindungsgemäßen Trennmediums zur Rückgewinnung von Kunststoffen, Gläsern, Halbleitern erwiesen.

Die auf eine Anlage der eingangs genannten Art gerichtete Aufgabe wird erfindungsgemäß gelöst durch eine derartige Anlage zur Durchführung des Verfahrens gemäß Ansprüche 9 bis 14, welche Mittel zum Erzeugen eine oder mehrere Schichten des Mehrschichtsystems durchdringender Defektstellen umfasst.

Zum Einwirken des Trennmediums auf das zu behandelnde Mehrschichtsystem kann die erfindungsgemäße Anlage mindestens einen Behälter, insbesondere Tauchbehälter, umfassen. Der Behälter dient zur Aufnahme des Trennmediums sowie der zu verarbeitenden Mehrschichtsysteme.

In Ausgestaltung der erfindungsgemäßen Anlage weist der Behälter rotierbare Trommeln auf, um die Kontaktierung des Trennmediums mit dem zu trennenden Mehrschichtsystem durch Rotation zu verbessern.

In weiterer günstiger Ausgestaltung der erfindungsgemäßen Anlage sind Fördermittel zum Erzeugen der Relativbewegung und/oder zum Ein- und/oder Austragen der zu trennenden Mehrschichtsysteme vorgesehen. Insbesondere können erfindungsgemäß die Fördermittel als eine oder mehrere Schnecken ausgestaltet sein.

Wenn in Weiterbildung der erfindungsgemäßen Anlage der Behälter eine plattenartige Ebene mit Mitteln zum Versetzen in eine Vibrationsbewegung aufweist, kann eine Kontaktierung des Trennmediums mit den zu trennenden Mehrschichtsystemen besonders günstig erreicht werden, wobei insbesondere mit Gegenströmung ein Partikelaustrag möglich ist.

Die Durchführung des erfindungsgemäßen Verfahrens gestaltet sich günstig, wenn erfindungsgemäß zunächst eine manuelle Demontage elektronischer Bauteile vorgenommen wird. Zweckmäßigerweise wird diese Demontage allen anderen Verfahrensschritten vorangestellt. Insbesondere sollte die Demontage vor einem Zerkleinerungsschritt erfolgen.

Die Erfindung wird in einer bevorzugten Ausführungsform unter Bezugnahme auf eine Zeichnung beispielhaft beschrieben, wobei weitere vorteilhafte Einzelheiten den Figuren der Zeichnung zu entnehmen sind.

Funktionsmäßig gleiche Teile sind dabei mit denselben Bezugszeichen versehen.

Die einzige Figur der Zeichnung zeigt im Einzelnen:
- Figur 1:: Ablaufschema einer bevorzugten Ausführungsform des erfindungsgemäßen Verfahrens unter Verwendung des erfindungsgemäßen Trennmediums;
- Figur 2:: Ablaufschema einer anderen Ausführungsform des erfindungsgemäßen Verfahrens zum Trennen von Mehrschichtsystemen

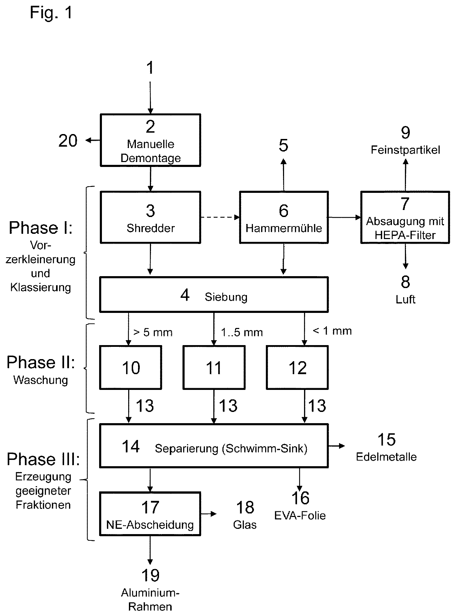

Figur 1 zeigt ein Ablaufschema zur Veranschaulichung einer bevorzugten Ausführungsform eines erfindungsgemäßen Verfahrens zum Trennen von Mehrschichtsystemen, insbesondere Photovoltaikmodulen, zum Zwecke des Recycling. Als Eingangsmaterial 1 für das Verfahren sind Module mit EVA-Klebung im Glas-Glasverbund/Glaskunststoff ggf. mit Rahmung geeignet. In einem vorgeschalteten Verfahrensschritt 2 erfolgt eine Demontage eventuell vorhandener elektronischer Bauteile wie zum Beispiel Anschlussdosen an dem Eingangsmaterial 1. Der vorgeschaltete Verfahrensschritt 2 kann an einem manuellen Demontagearbeitsplatz erfolgen.

Im nächsten Schritt 3 erfolgt eine Vorzerkleinerung des Eingangsmaterials 1, dessen Elektronikbestandteile im vorgeschalteten Verfahrensschritt 2 entfernt worden sind. Durch die Vorzerkleinerung im Verfahrensschritt 3 ergibt sich eine vergrößerte Angriffsfläche für die erfindungsgemäßen nanoskalige Dispersionen. Vorteilhafte Folge sind verkürzte Prozesszeiten. Im Schritt 4 wird das nach dem Zerkleinerungsschritt 3 erhaltene Material durch Siebung einer Klassierung unterzogen.

Gleichermaßen kann als Eingangsmaterial 5 auch eine Menge von Modulen ohne Verklebung als Halbzeug verwendet werden. Dieses wird einer Hammermühle 6 zugeführt und in dieser zerkleinert. Beim Zerkleinerungsschritt 3 bzw. in der Hammermühle 6 entstandener Staub wird gemäß dem Absaugungsschritt 7 vorzugsweise mit einem HEPA-Filter (HEPA: high efficiency particulate air filter) in gefilterte Luft 8 und Feinstpartikel 9 getrennt.

Als Ergebnis der Siebung liegt das im Zerkleinerungsschritt 3 zerkleinerte Eingangsmaterial 1 bzw. in der Hammermühle 6 zerkleinerte alternative Eingangsmaterial 5 gemäß dem hier beschriebenen Ausführungsbeispiel in drei verschiedenen Größen vor. Die Siebung gemäß Schritt 4 hat den Vorteil, Grobmaterial und Partikel voneinander zu trennen, welche in den Bädern 10, 11, 12 unterschiedliche Trenneigenschaften aufweisen. Der Vorteil der Siebung ist nach der Erfindung, dass bei großen Materialien große Partikel abgewaschen werden können, welche einfacher zu filtern sind. Andererseits führen kleine Glassplitter mit noch kleineren Partikeln zu einem hohem Filter-/Separierungsaufwand. Zudem ist das Verhältnis 95% >5mm zu 5% <1mm nutzbar.

Die Siebung gemäß Schritt 4 erfolgt gemäß dem hier beschriebenen Ausführungsbeispiel mit einem einfachen Taumelsieb. Nach der Siebung 4 können in dem Schema gemäß Figur 1 nicht dargestellte Dosierbehälter zur Zwischenpufferung eingesetzt werden, welche dann für die Befüllung der Bäder 10, 11, 12 zwecks Durchführung des eigentlichen Trennungsverfahrens dienen.

Die Bäder 10, 11, 12 werden bis zu einem Volumen von etwa 40 % mit Scherben des Eingangsmaterials 1 bzw. des alternativen Eingangsmaterials 5 befüllt. Die verbleibenden etwa 60 % des Volumens jedes Bades 10, 11, 12 werden mit erfindungsgemäßen nanoskaligen Dispersionen aufgefüllt. Die nanoskalige Dispersion kann insbesondere spezifisch auf das Eingangsmaterial 1 bzw. das alternative Eingangsmaterial 5 abgestimmt sein, um kostenminimierend eine optimale Prozesszeit zu erreichen. Es ist im Rahmen der Erfindung aber auch möglich, nanoskalige Dispersionen zu verwenden, die unterschiedliche Photovoltaikmodule der oben genannten Art in gleicher Weise trennen können.

Die nanoskaligen Dispersionen gemäß der Erfindung sind wie in der Beschreibungseinleitung offenbart zusammengesetzt. Insbesondere sind sie gemäß einer der folgenden Zusammensetzungen aufgebaut, bei denen jeweils der zu 100% fehlende Teil mit Wasser aufgefüllt wird.:

**Beispiel 1**

| **Komponente** | **Gew.%** | **Stoff** | **Beitrag zur wässrigen Komponente** |
|---|---|---|---|
| anionisches Tensid | 17,8 | Leuna-Alkansulfonat 30 (Natriumalkansulfonatgemisch der mittleren Kettenlänge C15 (C12-C18) basierend auf n-Paraffin - 34 %ige wässrige Lösung | 11,8 |
| nicht-ionisches Tensid | 5,9 | Polyethylenglykol-mono-n-dodecyl/tridecyl/tetradecyl/-pentadecylether als Stoffgemisch von Verbindungen mit 4 bis 25 Ethylenoxid -Einheiten | |
| Hydrotrop | 3,5 | Cublen R 60 [N-(2-Hydroxyethyl)-N, N-bis-methylenphosphonsäure in Form einer 60 %igen wässrigen Lösung | 1,4 |
| Cotensid | 8,9 | Butanol-2 | |
| organ. Phase | 7,0 | Xylen (techn.) | |
| Wasserzugabe | 56,90 | | |
| ges. wässrige Komponente | 70,1 | Summe aus Wasserzugabe und Beiträgen zur wässr. Komponente | |

**Beispiel 2:**

| **Komponente** | **Gew.-%** | **Stoff** | **Beitrag zur wässrigen Komponente** |
|---|---|---|---|
| anionisches Tensid | 6,0 | Leuna Alkansulfonat 95 (Natriumalkansulfonatgemisch der mittleren Kettenlänge C15 (C12-C18) basierend auf n-Paraffin) | |
| nicht-ionisches Tensid | 6,0 | Polyethylenglykol-mono-n-dodecyl /tetradecylether als Stoffgemisch mit 9 Ethylenoxid-Einheiten | |
| Hydrotrop | 2,0 | Dimethylaminomethan-bisphosphonsäure | |
| Cotensid | 9,0 | Ethylhexanol | |
| organische Phase | 8,0 | Mesitylen | |
| Wasserzugabe | 69,0 | | |
| ges. wässrige Komponente | 69,0 | Summe aus Wasserzugabe und Beiträgen zur wässr. Komponente | |

Bei den nanoskaligen Dispersionen gemäß Beispiel 2 kann durch Zugabe von NaOH der pH-Wert hochgesetzt werden.

**Beispiel 3:**

| **Komponente** | **Gew.%** | **Stoff** | **Beitrag zur wässrigen Komponente** |
|---|---|---|---|
| amphoteres Tensid | 5,0 | N, N-Dimethyl-N-tetradecylammoniopropansulfonat | |
| nicht-ionisches Tensid | 6,0 | Polyethylenglykol-mono-n-dodecyl /tetradecylether als Stoffgemisch mit 9 Ethylenoxid-Einheiten | |
| Hydrotrop | 2,0 | Dimethylaminomethan-bisphosphonsäure | |
| Cotensid | 9,0 | Ethylhexanol | |
| organische Phase | 7,0 | Hydrosol P 180 EA | |
| Wasserzugabe | 71,0 | | |
| ges. wässrige Komponente | 71,0 | Summe aus Wasserzugabe und Beiträgen zur wässr. Komponente | |

Bei dem Beispiel 3 wird im Unterschied zu den Beispielen 1 und 2 anstelle eines anionischen Tensids ein amphoteres Tensid verwendet.

**Beispiel 4**

| **Komponente** | **Gew.-%** | **Stoff** | **Beitrag zur wässrigen Komponente** |
|---|---|---|---|
| amphoteres Tensid | 3,0 | N, N-Dimethyl-N-tetradecyl-ammoniopropansulfonat | |
| anionisches Tensid | 4,0 | Leuna Alkansulfonat 95 (Natriumalkansulfonatgemisch der mittleren Kettenlänge C15 (C12-C18), basierend auf n-Paraffin | |
| nicht-ionisches Tensid | 6,0 | Polyethylenglykol-mono-n-dodecyl /tetradecylether als Stoffgemisch mit 9 Ethylenoxid-Einheiten | |
| Hydrotrop | 2,0 | Dimethylaminomethan-bisphosphonsäure | |
| Cotensid | 9,0 | Butylglykolether | |
| organische Phase | 5,0 | Dieselkraftstoff | |
| Wasserzugabe | 71 | | |
| ges. wässrige Komponente | 71,0 | Summe aus Wasserzugabe und Beiträgen zur wässr. Komponente | |

Bei dem Beispiel 4 wird zusätzlich zu dem nicht-ionischen Tensid sowohl ein anionisches Tensid als auch ein amphoteres Tensid verwendet.

Eine oder mehrere der genannten nanoskaligen Dispersionen wirken in den Bädern 10, 11, 12 für eine bestimmte Einwirkzeit, welche von den Eigenschaften des Eingangsmaterials 1 bzw. des alternativen Eingangsmaterials 5 abhängt, ein. Die Einwirkung erfolgt durch umfassende und eine gewisse Zeit dauernde Benetzung an mehreren Ansatzstellen, an denen das Trennmedium zwischen die zu trennenden Schichten eindringen, an der Grenzfläche entlang wandern und dort die Haftung auflösen kann. Dies muss nicht unbedingt in Tauchbehältern 11,12,13 erfolgen.

Im Anschluss an den Trennprozess in den Bädern 10, 11, 12 wird beladenes Trennmedium 13 in einem Separierungsschritt 14 behandelt. Der Separierungsschritt 14 dient zum Separieren der nach dem Waschvorgang in den Bädern 10, 11, 12 separat vorliegenden Bestandteile des Eingangsmaterials 1 bzw. des alternativen Eingangsmaterials 5 sowie des Trennmediums in Form von nanoskaliger Dispersion. Dieser Schritt ist in Figur 1 nur schematisch dargestellt. Im einfachsten Fall ist eine Schwimm-Sink-Separierung in Verbindung mit geeigneter Filterung ausreichend. Die im beladenen Trennmedium enthaltenen leichten Partikel mit großem Oberflächen-Volumen Verhältnis der abgelösten Schichten können von größeren schwereren Partikeln wie Glasfragmenten mit kleinem Oberflächen Volumen Verhältnis abgetrennt werden. Die Separation erfolgt unter Ausnutzung der Schwerkraft, des Strömungsverhaltens und/oder der Oberflächenspannung. Einfache Filterungen können erfindungsgemäß ebenfalls zum Zwecke der Separation eingesetzt werden. Die verbleibenden Bestandteile, also vor allem Glas, EVA, Aluminium, werden in nachgelagerten Prozessschritten, welche auch in nachgelagerten Anlagenteilen durchgeführt werden können, getrennt. Zum Beispiel lässt sich EVA durch Schwimm-Sink-Separierung trennen, Glas durch Absetzen im gleichen Behälter, Aluminium durch Abscheidung der Nicht-Eisen-Bestandteile. Diese Schritte können jeweils in separaten Anlagenteilen oder auch in demselben Anlagenteil durchgeführt werden.

Wie in der Figur 1 zu erkennen, werden Edelmetalle 15, EVA-Folie 16 sowie Nicht-Eisen-Abscheidungen 17 aus dem beladenen Trennmedium 13 separiert. Unter dem Begriff Nicht-Eisen-Abscheidungen 17 werden im Rahmen der vorliegenden Schrift Abscheidungen von Nicht Eisen-Bestandteilen, wie zum Beispiel von Glas oder Aluminium, verstanden. In einem separaten Separierungsprozess, welcher in der Figur 1 nicht weiter dargestellt ist, werden die Nicht-Eisen-Abscheidungen 17 ihrerseits nochmals nach den Wertstoffen Glas 18 sowie dem Aluminiumrahmen 19 aufgetrennt. Die genannten Wertstoffe, also Edelmetalle 15, EVA-Folie 16, Nicht-Eisen-Abscheidungen 17, umfassend Glas 18 und Aluminiumrahmen 19, liegen nach der erfindungsgemäßen Behandlung mit erfindungsgemäßer nanoskaliger Dispersion nicht, wie im Falle von herkömmlichen Verfahren, in gelöstem Zustand vor. Daher gestaltet sich die Separierung in dem Schritt 14 technisch einfacher. Zudem ist die Qualität der erhaltenen Recyclingmaterialien 15, 16, 17, 18, 19 hinsichtlich deren Wiederverwertbarkeit nicht durch das Recyclingverfahren selber eingeschränkt.

Im günstigsten Fall können die im vorgeschalteten Verfahrensschritt 2 bei der Demontage elektronischer Bauteile erhaltenen elektronischen Bauteile 20 ebenfalls einer Verwertung zugeführt werden.

Nach dem vorgeschalteten Verfahrensschritt 2 kann das erfindungsgemäße Verfahren somit in die folgenden drei wesentlichen Verfahrensgruppen gegliedert werden:
- Phase I:: Vorzerkleinerung und Klassierung,
- Phase II:: Waschung mit nanoskaliger Dispersion
- Phase II:: Erzeugung geeigneter Fraktionen für die Verwertung.

Auf diese Weise ist erfindungsgemäß ein Verfahren, eine Anlage zur Durchführung des Verfahrens, ein Trennmedium sowie eine Verwendung des Trennmediums vorgeschlagen, welche eine verbesserte Trennung von Mehrschichtsystemen zum Zwecke des Recycling, insbesondere hinsichtlich einer Rückgewinnungsquote und der Qualität der erhaltenen Wertstoffe 15, 16, 17, 18, 19, vorgeschlagen.

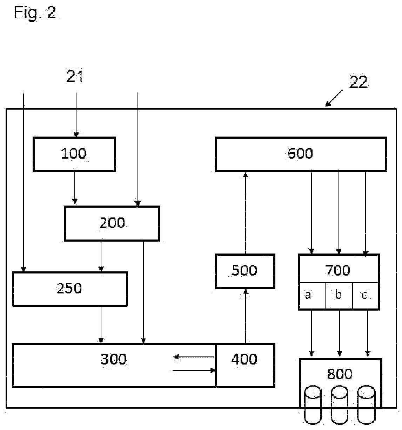

Die Figur 2 zeigt schematisch eine andere bevorzugte Ausgestaltung des erfindungsgemäßen Verfahrens zum Trennen von Mehrschichtsystemen. Wie in dem schematischen Fließdiagramm gemäß Figur 2 zu erkennen, wird zu trennendes Mehrschichtmaterial 21 einer Anlage 22 zum Trennen von Mehrschichtmaterial zugeführt. Dabei kann das Mehrschichtmaterial 21 wahlweise zunächst einer Vorstufe 100 zur Demontage zugeführt werden. In der Vorstufe 100 werden separat zu behandelnde Teile, beispielsweise Teile, die nicht aus einem mehrschichtigen Material, welches zu trennen ist, bestehen, entfernt. Außerdem können in der Vorstufe 100 Teile des zu trennenden Mehrschichtmaterials 21 abgetrennt werden, welche aufgrund der Art des Mehrschichtmaterials einer anderen Behandlung unterzogen werden müssen, als beispielsweise eine Hauptkomponente des Mehrschichtmaterials.

Nach Durchlaufen der Vorstufe 100 wird der Teil des Mehrschichtmaterials 21, der nach der Demontage verbleibt, einer weiteren Vorstufe 200 zur Erzeugung von Angriffskanten zugeführt. Alternativ kann das Mehrschichtmaterial 21 auch direkt der Vorstufe 200 zur Erzeugung von Angriffskanten innerhalb der Anlage 1000 zum Trennen von Mehrschichtmaterialien zugeführt werden. Dies wird zweckmäßig sein, wenn eine Demontage nicht erforderlich oder gewünscht ist. Innerhalb der Vorstufe 200 zur Erzeugung von Angriffskanten werden eine oder mehrere Schichten des Mehrschichtsystems durchdringende Defektstellen erzeugt, um eine Vergrößerung der Angriffsfläche für das Trennmedium zu erzeugen. Dies kann durch Anritzen des Mehrschichtsystems mit mechanischen Schneidmitteln, durch Behandlung mit Laserstrahlen, mittels Beschießen mit scharfkantigen Partikeln, beispielsweise mit Sandstrahlen, mittels Knicken, Brechen, Shreddern, Mahlen oder anderen üblichen, dem Fachmann für sich genommen bekannten Verfahren erfolgen.

Im Anschluss an die Vorstufe 200 zur Erzeugung von Angriffskanten wird das zu bearbeitende Mehrschichtmaterial 21 einer Zwischenlagerungsstufe 250 zugeführt. In der Zwischenlagerungsstufe 250 ist es zudem möglich, eine für die nachfolgende Bearbeitungsstufe geeignete Beschickung sicherzustellen. In der Zwischenlagerstufe 250 kann auch eine Mischung unterschiedlichen Beschickungsgutes vorgenommen werden.

Aus der Zwischenlagerungsstufe 250, welche insbesondere das Zwischenlagern in geeigneten Behältern beinhaltet, wird das zu bearbeitende Mehrschichtmaterial 21 einer Benetzungsstufe 300 zugeführt. Innerhalb der Benetzungsstufe 300 wird das zu trennende Mehrschichtmaterial 21 mit erfindungsgemäßem Trennmittel benetzt. Dies erfolgt vorzugsweise in einem das Trennmittel enthaltenden Tauchbad oder in Form einer Berieselungsstraße.

Im Anschluss an die Benetzungsstufe 300 wird mit dem zu trennenden Mehrschichtmaterial 21 eine Abtrennstufe 400 durchlaufen. Innerhalb der Abtrennstufe 400 wird das aufgrund der während der Benetzungsstufe 300 delaminierte Schichtmaterial von einem Substratmaterial als Bestandteil des Mehrschichtmaterials 21 abgetrennt und, ohne dabei in Lösung zu gehen, von dem erfindungsgemäßen Trennmittel aufgenommen. Der Vorgang kann durch eine Umwälzung des erfindungsgemäßen Trennmittels begünstigt werden. Dies ist durch die Pfeile zwischen den Stufen 300 und 400 in der Figur 2 angedeutet.

An die Abtrennstufe 400 schließt sich eine Separationsstufe 500 an. Während der Separationsstufe 500 werden während der Abtrennstufe 400 von dem erfindungsgemäßen Trennmittel aufgenommene Schichtfragmente durch ein geeignetes Verfahren abgetrennt. Dies erfolgt beispielsweise durch Aufschwimmen in Luftblasenstrom nach einem sogenannten floating Verfahren, durch Schwimm-Sink-Separation oder durch Filtration.

Im Anschluss an die Separationsstufe 500 schließt sich eine Fragmentierstufe 600 an, bei welcher die während der Abtrennstufe 400 abgetrennten und in der Separationsstufe 500 vom flüssigen erfindungsgemäßen Trennmedium separierten Schichtfragmente in unterschiedliche Materialfraktionen fragmentiert werden.

Im Anschluss an die Fragmentierstufe 600 werden die einzelnen Materialfraktionen a, b, c in einer Nachbehandlungsstufe 700 weiter veredelt. Die Veredelung der einzelnen Materialfraktionen a, b, c kann zum Beispiel in einer Aufschlüsselung, Reinigung bzw. in einer physikalischen oder chemischen Bearbeitung bestehen.

Abschließend werden die im Rahmen der Nachbehandlungsstufe 700 veredelten Materialfraktionen a, b, c einer Verpackungsstufe 800 zugeführt und jeweils getrennt zur Verwendung verpackt.

### BEZUGSZEICHENLISTE

- 1: Eingangsmaterial
- 2: Vorgeschalteter Verfahrensschritt
- 3: Zerkleinerungsschritt
- 4: Siebung
- 5: Alternatives Eingangsmaterial
- 6: Hammermühle
- 7: Absaugungsschritt
- 8: gefilterte Luft
- 9: Feinstpartikel
- 10: Bad
- 11: Bad
- 12: Bad
- 13: beladenes Trennmedium
- 14: Separierungsschritt
- 15: Edelmetalle
- 16: EVA-Folie
- 17: Nicht-Eisen-Abscheidungen
- 18: Glas
- 19: Aluminiumrahmen
- 20: Elektronikbauteile
- I: Verfahrensphase
- II: Verfahrensphase
- III: Verfahrensphase
- 21: Mehrschichtmaterial
- 22: Anlage zum Trennen von Mehrschichtmaterial
- 100: Vorstufe zur Demontage
- 200: Vorstufe zur Erzeugung von Angriffskanten
- 250: Zwischenlagerungsstufe
- 300: Benetzungsstufe
- 400: Abtrennstufe
- 500: Separationsstufe
- 600: Fragmentierstufe
- 700: Nachbehandlungsstufe
- 800: Verpackungsstufe

## Patentansprüche

1. Verwendung eines Trennmediums zum Trennen von Mehrschichtsystemen (1, 5), zum Zwecke des Recyclings, wobei das Trennmedium eine nanoskalige Dispersion ist, welche aus einer organischen Komponente, einer wässrigen Komponente und mindestens einem Tensid gebildet ist.

2. Verwendung nach Anspruch 1, **dadurch gekennzeichnet, dass** das Tensid gewählt ist aus der Gruppe gebildet durch anionische Tenside, nicht-ionische Tenside, amphotere Tenside, oder deren Kombinationen.

3. Verwendung nach Anspruch 1 oder 2, **dadurch gekennzeichnet, dass** das Trennmedium mindestens ein anionisches Tensid und ein oder mehrere Tenside, ausgewählt aus der Gruppe gebildet durch nicht ionische Tenside oder amphotere Tenside, enthält.

4. Verwendung nach einem der Ansprüche 1 bis 3, **dadurch gekennzeichnet, dass** die nanoskalige Dispersion weiter ein Hydrotrop zur Stabilisierung der Dispersion enthält.

5. Verwendung nach Anspruch 4, **dadurch gekennzeichnet, dass**
das Hydrotrop ein kurzkettiges, polares organisches Molekül, eine organische Säure oder ein Salz einer organischen Säure umfasst.

6. Verwendung nach einem der Ansprüche 1 bis 5, **dadurch gekennzeichnet, dass** die nanoskalige Dispersion ein Cotensid, vorzugsweise einen kurzkettigen Alkohol, enthält.

7. Verwendung nach einem der Ansprüche 1 bis 6, **dadurch gekennzeichnet, dass** die wässrige Komponente innerhalb der nanoskaligen Dispersion eine Konzentration von mindestens 60 Gewichts-%, vorzugsweise etwa 70 Gewichts-%, aufweist.

8. Verfahren zum Trennen von Mehrschichtsystemen (1, 5) zum Zwecke des Recyclings, umfassend: eine Waschung mit einem Trennmedium zur Abtrennung mittels des Trennmediums von zumindest Abschnitten einzelner oder mehrerer Schichten des Mehrschichtsystems, wobei das Material der Schichten im Wesentlichen nicht in Lösung geht und das Trennmedium eine nanoskalige Dispersion ist, welche aus einer organischen Komponente, einer wässrigen Komponente und mindestens einem Tensid gebildet ist.

9. Verfahren nach Anspruch 8, wobei die Waschung in einem das Trennmedium enthaltenden Behälter (11, 12, 13) durchgeführt wird, indem die zu trennenden Mehrschichtsysteme in den Behälter (11, 12, 13) eingetragen werden, wobei vorzugsweise eine Relativbewegung zwischen dem Trennmedium und dem Behälter (11, 12, 13) erzeugt wird.

10. Verfahren nach einem der Ansprüche 8 oder 9, **dadurch gekennzeichnet, dass** die Mehrschichtsysteme vor der Waschung mechanisch zerkleinert werden und/oder eine Größenklassierung (4) vorgenommen wird.

11. Verfahren nach einem der Ansprüche 8 bis 10, **dadurch gekennzeichnet, dass** nach der Waschung eine Separierung (14) abgetrennter Bestandteile des Mehrschichtsystems durchgeführt wird.

12. Verfahren nach Anspruch 11, **dadurch gekennzeichnet, dass**
die Separierung (14) mittels eines Filterverfahrens durchgeführt wird, indem abgetrennte Bestandteile des Mehrschichtsystems, vorzugsweise mechanisch, zurückgehalten werden.

13. Verfahren nach einem der Ansprüche 8 bis 12, **dadurch gekennzeichnet, dass** das Trennmedium nach der Waschung zurückgewonnen und wiederverwendet wird.

14. Anlage zur Durchführung des Verfahrens nach einem der Ansprüche 8 bis 13, umfassend mindestens einen Behälter (10, 11, 12) zur Aufnahme der zu trennenden Mehrschichtsysteme (1, 5), und eines Trennmediums, wobei das Trennmedium eine nanoskalige Dispersion ist, welche aus einer organischen Komponente, einer wässrigen Komponente und mindestens einem Tensid gebildet ist.

15. Anlage nach Anspruch 14, weiter umfassend eine Separierungseinheit (14).

## Claims

1. A use of a separation medium for separating multi-layer system (1, 5) for the purpose of recycling, wherein the separation medium is a nanoscale dispersion formed from an organic component, an aqueous component, and at least one surfactant.

2. The use of claim 1, **characterized in that** the surfactant is selected from the group formed of anionic surfactants, non-ionic surfactants, amphoteric surfactants, or combinations thereof.

3. The use of claim 1 or 2, **characterised in that**
the separation medium contains at least one anionic surfactant and one or more surfactants selected from the group formed of non-ionic surfactants or amphoteric surfactants.

4. The use of one of claims 1 to 3, **characterised in that**
the nano-scale dispersion further contains a hydrotrope for stabilisation of the dispersion.

5. The use of claim 4, **characterised in that**
the hydrotrope comprises a short-chain polar organic molecule, an organic acid, or a salt of an organic acid.

6. The use of one of claims 1 to 5, **characterised in that**
the nanoscale dispersion contains a co-surfactant, and preferably a short-chain alcohol.

7. The use of one of claims 1 to 6, **characterised in that**
the aqueous component has within the nanoscale dispersion a concentration of at least 60 wt.%, and preferably 70 wt.%.

8. A method for separating of multi-layer systems (1, 5) for the purpose of recycling, comprising: a washing with a separation medium for separation by means of the separation medium of at least portions of single or several layers of the multi-layer system, wherein the material of the layers substantially does not pass into solution, and the separation medium is a nanoscale dispersion, which is formed from an organic component, an aqueous component, and at least one surfactant.

9. The method of claim 8, wherein the washing is performed in a container (11, 12, 13) containing the separation medium, by introducing into the container (11, 12, 13) the multi-layer systems to be separated, wherein preferably a relative movement between the separation medium and the container (11, 12, 13) is generated.

10. The method of one of claims 8 or 9, **characterised in that**
the multi-layer systems are mechanically shredded before the washing, and/or a size classification (4) is performed

11. The method of claim 8 to 10, **characterised in that**
a separation (14) of separated components of the multi-layer system is performed after the washing.

12. The method of claim 11, **characterised in that**
the separation (14) is performed by means of a filtration method, by, preferably mechanically, retaining separated components of the multi-layer system.

13. The method of one of claims 8 to 12, **characterised in that**, after the washing, the separation medium is recovered and re-used.

14. A system for performing the method of one of claims 8 to 13, comprising at least one container (10, 11, 12) for receiving the multi-layer systems (1, 5), to be separated, and a separation medium, wherein the separation medium is a nanoscale dispersion, which is formed by an organic component, an aqueous component, and at least one surfactant.

15. The system of claim 14, further comprising a separation unit (14).

## Revendications

1. Utilisation d'un milieu de séparation pour la séparation de systèmes multicouches (1,5) en vue du recyclage dans lequel le milieu de séparation est une dispersion nanométrique, qui est formée d'un composant organique, d'un composant aqueux et au moins d'un tensioactif.

2. Utilisation selon la revendication 1, **caractérisée en ce que** le tensioactif est choisi du groupe formé de tensioactifs anioniques, non ioniques, amphotères ou d'une combinaison de ces derniers.

3. Utilisation selon la revendication 1 ou 2, **caractérisée en ce que** le milieu de séparation comprend au moins un tensioactif anionique et un ou plusieurs tensioactifs choisis du groupe formé de tensioactifs non ioniques ou amphotères.

4. Utilisation selon une des revendications 1 à 3, **caractérisée en ce que** la dispersion nanométrique comprend en outre un hydrotrope pour la stabilisation de la dispersion.

5. Utilisation selon la revendication 4, **caractérisée en ce que** l'hydrotope comprend une molécule organique à chaîne courte polaire, un acide organique ou un sel d'un acide organique.

6. Utilisation selon une des revendications 1 à 5, **caractérisée en ce que** la dispersion nanométrique comprend un co-tensioactif, de préférence un alcool à chaîne courte.

7. Utilisation selon une des revendications 1 à 6, **caractérisée en ce que** le composant aqueux dans la dispersion nanométrique comporte au moins 60 % en poids, par préférence 70 % en poids.

8. Procédé pour la séparation de systèmes multicouches (1,5) en vue du recyclage comprenant : un lavage avec un milieu de séparation pour la séparation au moyen d'un milieu de séparation d'au moins quelques parties de certaines ou plusieurs couches du système multicouches, dans lequel le matériel des couches ne se dissout essentiellement pas et le milieu de séparation est une dispersion nanométrique, laquelle est formée d'un composant organique, un composant aqueux et d'au moins un tensioactif.

9. Procédé selon la revendication 8, dans lequel le lavage est effectué dans un récipient (11, 12, 13) qui comprend le milieu de séparation tout en installant les systèmes multicouches à séparer dans le récipient (11, 12, 13 dans lequel un mouvement relatif est par préférence créé entre le milieu de séparation et le récipient (1 I, 12, 13).

10. Procédé selon une des revendications 8 ou 9, **caractérisée en ce que** les systèmes multicouches sont broyés mécaniquement avant le lavage et/ou classifiés selon la taille (4).

11. Procédé selon une des revendications 8 à 10, **caractérisé en ce que**, après le lavage, une séparation (14) des composants enlevés du système multicouches est effectuée.

12. Procédé selon la revendication 11 **caractérisé en ce que** la séparation (14) est effectuée par un procédé de filtration en retenant, par préférence mécaniquement, les composants enlevés.

13. Procédé selon une des revendications 8 à 12, **caractérisé en ce que** le milieu de séparation est récupéré et recyclé après le lavage.

14. Installation pour l'effectuation du procédé selon une des revendications 8 à 13, comprenant au moins un récipient (10, 11, 12) pour l'insertion des systèmes multicouches à séparer (1, 5), et d'un milieu de séparation, dans lequel le milieu de séparation est une dispersion nanométrique qui est formée d'un composant organique, d'un composant aqueux et d'au moins un tensioactif.

15. Installation selon la revendication 14, comprenant en outre une unité de séparation (14).
